(19) Europäisches Patentamt

European Patent Office

Office européen des brevets

(11) Numéro de publication: **0 193 464 B1**

# (12) FASCICULE DE BREVET EUROPEEN

(45) Date de publication de fascicule du brevet:
**28.08.91**

(21) Numéro de dépôt: **86400394.2**

(22) Date de dépôt: **25.02.86**

(51) Int. Cl.⁵: **H05B 3/26, B41C 1/14, B41M 1/12, B41M 1/34**

---

(54) **Procédé de fabrication d'une vitre chauffable et pochoir de sérigraphie pour l'exécution du procédé.**

---

(30) Priorité: **27.02.85 DE 3506891**

(43) Date de publication de la demande:
**03.09.86 Bulletin 86/36**

(45) Mention de la délivrance du brevet:
**28.08.91 Bulletin 91/35**

(84) Etats contractants désignés:
**BE DE FR GB IT SE**

(56) Documents cités:
| | |
|---|---|
| **BE-A- 788 677** | **DE-A- 2 856 391** |
| **FR-A- 1 052 526** | **FR-A- 2 075 352** |
| **FR-A- 2 188 501** | **FR-A- 2 330 539** |
| **US-A- 2 278 771** | **US-A- 3 851 581** |

(73) Titulaire: **SAINT-GOBAIN VITRAGE INTERNATIONAL**
**18, avenue d'Alsace**
**F-92400 Courbevoie(FR)**

(84) Etats contractants désignés:
**BE FR GB IT SE**

Titulaire: **VEGLA Vereinigte Glaswerke GmbH**

**Viktoriaallee 3-5**
**W-5100 Aachen(DE)**

(84) Etats contractants désignés:
**DE**

(72) Inventeur: **Karla, Heinz M.**
**Albert-Steiner Strasse 9**
**W-5120 Herzogenrath(DE)**
Inventeur: **Hahn, Dieter M.**
**Adolf Strasse 22**
**W-5132 Uebach-Palenberg(DE)**

(74) Mandataire: **Muller, René et al**
**SAINT-GOBAIN RECHERCHE 39, quai Lucien Lefranc**
**F-93304 Aubervilliers(FR)**

---

## Description

La présente invention concerne un procédé de fabrication d'une vitre chauffable, en particulier pour automobiles, par impression d'un ensemble de conducteurs constitué de conducteurs collectifs et de conducteurs chauffants faits d'une pâte se prêtant à l'impression au moyen du procédé de sérigraphie, selon lequel on utilise un pochoir de sérigraphie à revêtement d'épaisseur uniforme dont le tissu sérigraphique présente dans le domaine des conducteurs collectifs, en vue d'obtenir une couche de pâte plus épaisse, une structure différente de celle du domaine des conducteurs chauffants. Elle comprend en outre un pochoir de sérigraphie pour la fabrication d'une vitre chauffable.

Un procédé du type spécifié plus haut est décrit dans le document DE-OS-32 31 382. Dans ce procédé connu, on obtient la couche de pâte plus épaisse dans le domaine des conducteurs collectifs par le fait que le pochoir de sérigraphie utilisé présente dans le domaine des conducteurs collectifs, des fils plus gros que dans le domaine des conducteurs chauffants. Par exemple, dans le domaine des conducteurs collectifs, les fils de trame doivent présenter une grosseur de 50 à 60 micromètres, tandis que dans tous les autres domaines du pochoir de sérigraphie, tant les fils de trame que les fils de chaîne présentent une grosseur de 39 micromètres.

Dans ce procédé connu, l'accroissement de l'épaisseur de la couche de pâte appliquée au moyen des fils de trame plus gros est partiellement annulé par le fait que l'aire de passage pour la pâte entre les fils du tissu est réduite dans la mesure dans laquelle le diamètre des fils est augmenté. L'invention a pour but d'atteindre le même effet, à savoir l'application d'une couche de pâte d'impression épaisse dans le domaine des conducteurs collectifs, d'une autre manière et avec une efficacité nettement accrue.

Suivant l'invention, ce but est réalisé par le fait qu'on utilise un pochoir de sérigraphie qui présente dans les domaines des conducteurs collectifs, des ouvertures de mailles plus grandes que dans les domaines des conducteurs chauffants.

Au moyen du procédé conforme à l'invention, dans le domaine des conducteurs collectifs, la surface couverte par les fils du tissu sérigraphique est en un certain sens réduite, de sorte qu'une surface accrue est disponible pour le passage de la pâte d'impression à travers les mailles du tissu sérigraphique. Par exemple, on peut utiliser avec de bons résultats un pochoir de sérigraphie qui présente dans son ensemble des fils de chaîne et de trame de grosseur uniforme et dans lequel l'espacement des fils de chaîne et/ou de trame est plus grand dans les domaines des conducteurs collectifs que dans les domaines des conducteurs chauffants.

Dans une réalisation avantageuse de l'invention, les domaines présentant des ouvertures de mailles plus grandes ou des espaces entre les fils plus grands s'étendent jusqu'à une profondeur plus ou moins grande dans les domaines prévus pour l'impression des conducteurs chauffants. De cette façon, il est possible d'imprimer des conducteurs chauffants qui présentent dans leurs domaines d'extrémité, comme les conducteurs collectifs, une épaisseur de couche accrue. Etant donné que dans le cas de conducteurs chauffants ainsi réalisés, la résistance électrique est plus faible dans les domaines d'extrémité des conducteurs chauffants que dans leur domaine médian, il est possible de fabriquer de cette façon des vitres chauffantes dont le domaine chauffant présente au centre, sur une longueur prédéfinie, une puissance de chauffage accrue, de sorte que ce domaine sera plus rapidement dégagé par chauffage.

Deux exemples de réalisation de l'invention seront décrits ci-après plus en détail avec référence aux dessins annexés qui illustrent en plan et non à l'échelle, un fragment d'un pochoir de sérigraphie, dans lesquels :

la Fig. 1 illustre un exemple de réalisation d'un pochoir de sérigraphie qui rend possible l'application d'une couche plus épaisse de la pâte d'impression dans les domaines des conducteurs chauffants, et

la Fig. 2 illustre un exemple de réalisation d'un pochoir de sérigraphie au moyen duquel il est possible d'obtenir une couche de pâte plus épaisse également dans les domaines des conducteurs chauffants adjacents aux conducteurs collectifs.

Le tissu sérigraphique est formé des fils de chaîne 1 verticaux et des fils de trame 2 perpendiculaires à ceux-ci. Le tissu sérigraphique est recouvert, dans les domaines dans lesquels aucun dépôt de pâte sérigraphique ne doit être effectué sur la vitre, selon des procédés connus, d'un revêtement 3. Des domaines en forme de bandes relativement larges 4, qui correspondent aux conducteurs collectifs, et des domaines en forme de bandes relativement étroites 5, qui débouchent dans les zones 4 et qui correspondent aux conducteurs chauffants, sont laissées exemptes du revêtement 3. Lors de l'opération de sérigraphie, la pâte d'impression est appliquée à travers les mailles de l'étoffe sérigraphique sur la vitre à travers ces domaines exempts du revêtement 3, lorsque la pâte d'impression est étendue au moyen d'une racle sur le pochoir de sérigraphie.

Tous les fils de chaîne et de trame 1, 2 du tissu sérigraphique ont, par exemple, un diamètre, de 30 à 40 micromètres. Alors que la distance entre les fils de chaîne l est la même dans tout le pochoir de sérigraphie et que l'espacement des fils de chaîne est, par exemple, de 50 à 60 micromètres, l'espacement des fils de trame 2 est également de 50 à 60 micromètres dans les domaines des conducteurs chauffants 5, mais il est de 130 à 160 micromètres dans les domaines des conducteurs collectifs 4, c'est-à-dire que dans ces domaines des conducteurs collectifs 4, comparés aux domaines comprenant les conducteurs chauffants, un seul fil de trame sur deux est présent. De cette façon, on obtient à l'intérieur des domaines des conducteurs collectifs 4, des mailles présentant une ouverture qui vaut plus de 2,5 fois l'ouverture d'une maille située dans les domaines des conducteurs chauffants 5.

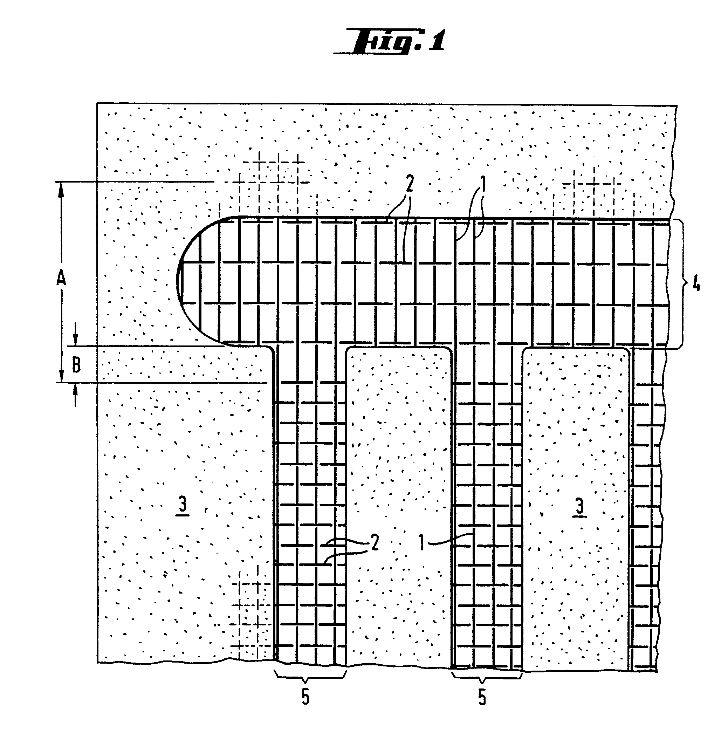

Dans le cas de l'exemple de réalisation représenté sur la Fig. 1, la zone présentant un plus grand espacement des fils de trame 2 a une largeur A, qui recouvre en substance les domaines en forme de bandes 4 qui correspondent aux conducteurs collectifs. Cette zone à grandes mailles s'étend dans une faible mesure B dans les domaines en forme de bandes 5 qui débouchent dans les domaines 4. De cette façon, la zone de transition directe entre les bandes 5 et les conducteurs collectifs 4 est également pourvue d'une couche de pâte d'impression plus épaisse, ce qui diminue le risque de points faibles qui se présente précisément dans ce domaine de transition.

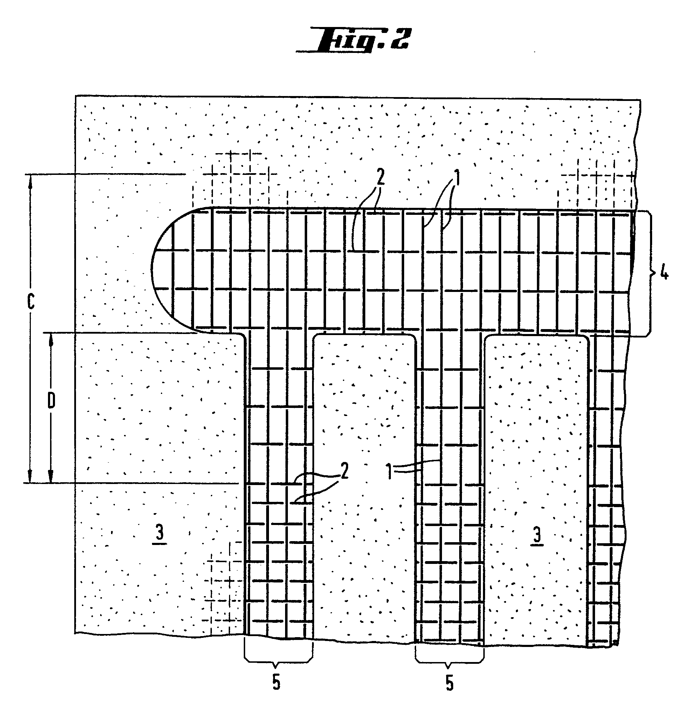

Dans l'exemple de réalisation illustré sur la Fig. 2, la zone C à grandes mailles est sensiblement plus large, de sorte que les domaines 5 en forme de bandes correspondant aux conducteurs chauffants présentent au niveau de leur jonction avec les domaines 4 correspondant aux conducteurs collectifs également des grandes mailles sur la distance D et permettent ainsi un dépôt plus épais de la pâte d'impression. Cette forme d'exécution permet de fabriquer des vitres chauffantes présentant un champ chauffant dans lequel les conducteurs chauffants exercent un effet de chauffage plus puissant au milieu que dans les domaines extérieurs adjacents aux conducteurs collectifs.

## Revendications

1. Procédé de fabrication d'une vitre chauffable, en particulier pour automobiles, par impression d'un ensemble de conducteurs constitué de conducteurs collectifs et de conducteurs chauffants faits d'une pâte se prêtant à l'impression au moyen du procédé de sérigraphie, selon lequel on utilise un pochoir de sérigraphie à revêtement d'épaisseur uniforme dont le tissu sérigraphique présente dans les domaines des conducteurs collectifs, en vue d'obtenir une couche de pâte plus épaisse, une structure différente de celle des domaines des conducteurs chauffants, caractérisé en ce qu'on utilise un pochoir de sérigraphie dont le tissu sérigraphique présente, dans les domaines des conducteurs collectifs, des mailles plus grandes que dans le domaine des conducteurs chauffants.

2. Procédé suivant la revendication 1, caractérisé en ce qu'on utilise un pochoir de sérigraphie qui présente des fils de grosseur uniforme dont l'espacement est plus grand dans les domaines des conducteurs collectifs que dans ceux des conducteurs chauffants.

3. Pochoir de sérigraphie pour la fabrication d'une vitre chauffable, dans lequel la soie sérigraphique recouverte d'une couche d'épaisseur uniforme présente, dans les domaines laissés exempts de revêtements destinés aux conducteurs collectifs, une structure différente de celle prévue pour les conducteurs chauffants, caractérisé en ce que dans les domaines des conducteurs collectifs, l'espacement des fils de chaîne et/ou des fils de trame est plus grand que dans les domaines des conducteurs chauffants.

4. Pochoir de sérigraphie suivant la revendication 3, caractérisé en ce que les domaines dans lesquels l'espacement des fils de chaîne et/ou des fils de trame est plus grand s'étendent jusque dans les domaines correspondant aux conducteurs chauffants.

## Claims

1. Process for the production of a heatable pane, especially for automobiles, by printing an assembly of conductors composed of feeder conductors and heating conductors made of a paste suitable for printing by the screen printing process, according to which a screen printing stencil plate having a covering of uniform thickness is used, of which the screen printing fabric has, in the regions of the feeder conductors, a structure different from that of the regions of the heating conductors in order to produce a thicker coating of paste, characterized in that a screen printing stencil plate is used, the screen printing fabric of which has, in the regions of the feeder conductors, a wider mesh than in the region of the heating conductors.

2. Process according to Claim 1, characterized in that a screen printing stencil plate is used which has threads of uniform size, the spacing of which is greater in the regions of the feeder conductors than in those of the heating conductors.

3. Screen printing stencil plate for the production of a heatable pane, in which the screen printing silk covered with a layer of uniform thickness has, in the regions left free of covering intended for the feeder conductors, a different structure from that provided for the heating conductors, characterized in that, in the regions of the feeder conductors, the spacing of the warp threads and/or the weft threads is greater than in the regions of the heating conductors.

4. Screen printing stencil plate according to Claim 3, characterized in that the regions in which the spacing of the warp and/or weft threads is greater extends somewhat into the regions corresponding to the heating conductors.

**Patentansprüche**

1. Verfahren zur Herstellung einer beheizbaren Glasscheibe, insbesondere für Kraftfahrzeuge, durch Aufdrucken einer aus Sammelleitern und Heizleitern bestehenden Leiteranordnung aus einer druckfähigen elektrisch leitenden Paste mit Hilfe des Siebdruckverfahrens, bei dem eine Siebdruckschablone mit gleichmäßig dikker Beschichtung verwendet wird, deren Siebdruckgewebe in den Bereichen der Sammelleiter zur Erzielung eines dickeren Pastenauftrags eine andere Struktur aufweist als in den Bereichen der Heizleiter, **dadurch gekennzeichnet,** daß eine Siebdruckschablone verwendet wird, deren Siebdruckgewebe in den Bereichen der Sammeleiter größere Maschenöffnungen aufweist als im Bereich der Heizleiter.

2. Verfahren nach Anspruch 1, dadurch gekennzeichnet, daß eine Siebdruckschablone verwendet wird, die einheitliche dicke Fäden aufweist, deren Abstand in den Bereichen der Sammelleiter größer ist als in denen der Heizleiter.

3. Siebdruckschablkone für die Herstelllung einer beheizbaren Glasscheibe, bei der die mit einer gleichmäßig dicken Schicht beschichtete Siebdruckseide in den Bereichen der Aussparungen der Schicht für die Sammelleiter eine andere Struktur aufweist als die für die Heizleiter vorgesehene Struktur, dadurch gekennzeichnet, daß in den Bereichen der SammelLeiter der gegenseitige Abstand der Kett- und/oder der Schußfäden größer ist als in den Bereichen der Heizleiter.

4. Siebdrucksschablone nach Anspruch 3, dadurch gekennzeichnet, daß die Bereiche mit größerem gegenseitigen Abstand der Kettund/oder der Schußfäden sich bis in die den Heizleitern entsprechenden Bereiche erstrekken.

Fig. 1

Fig.2